# EUROPÄISCHE PATENTSCHRIFT

(11) **EP 1 774 654 B1**
(45) Veröffentlichungstag und Bekanntmachung des Hinweises auf die Patenterteilung: **06.02.2008**
(21) Anmeldenummer: 05763087.3
(22) Anmeldetag: 21.07.2005
(51) Int. Cl.: H03K 19/003, G01R 31/30

(54) **VERFAHREN UND VORRICHTUNG ZUR BESCHALTUNG VON EINGÄNGEN BEI MICROCONTROLLERN SOWIE ENTSPRECHENDER MICROCONTROLLER**
METHOD AND DEVICE FOR THE CONNECTION OF INPUTS FOR MICROCONTROLLERS AND CORRESPONDING MICROCONTROLLER
PROCEDE ET DISPOSITIF DE COMMUTATION D'ENTREES DE MICROCONTROLEURS ET MICROCONTROLEUR CORRESPONDANT

(30) Priorität: 26.07.2004 DE 102004036173
(43) Veröffentlichungstag der Anmeldung: 18.04.2007
(73) Patentinhaber: ROBERT BOSCH GMBH, 70442 Stuttgart (DE)
(72) Erfinder: MITTER, Carsten, 37194 Wahlsburg (DE)
(86) Internationale Anmeldenummer: PCT/EP2005/053560
(87) Internationale Veröffentlichungsnummer: WO 2006/010739

(56) Entgegenhaltungen:
- US-A- 5 097 206
- US-A- 5 670 890
- US-A- 5 701 115

## Beschreibung

### Stand der Technik

Die Erfindung betrifft ein Verfahren und eine Vorrichtung zur Beschaltung von Konfigurationseingängen eines Mikrocontrollers, wobei an jedem Konfigurationseingang ein Signalzustand aus wenigstens zwei möglichen Signalzuständen einzustellen ist gemäß den Oberbegriffen der unabhängigen Ansprüche. Daneben betrifft die Erfindung einen Microcontroller, der eine solche Vorrichtung enthält.

Microcontroller sind zentraler Bestandteil moderner elektronischer Steuergeräte. Für eine ordnungsgemäße Funktion ist im Allgemeinen eine elektrisch leitende Verbindung zwischen den Funktionseinheiten des Microcontrollers und der umgebenden Schaltung erforderlich. Dies gilt auch für sogenannte System- und Konfigurationseingänge, über die bestimmte konfigurierbare Eigenschaften definiert werden. Diese Eingänge werden im Weiteren als Konfigurationseingänge bezeichnet und sind im Allgemeinen nicht mit der eigentlichen umgebenden Schaltung verbunden, sondern fest mit einer Versorgungsspannung Vcc oder mit dem Massepotential Vss der Schaltung verbunden. D. h. dass an diesen Konfigurationseingängen jeweils ein Signalzustand aus wenigstens zwei möglichen Signalzuständen einzustellen ist.

Aufgrund unterschiedlicher Ursachen kann eine solche Verbindung zur Erzielung des entsprechenden Signalzustandes am Konfigurationseingang jedoch nicht wie gewünscht zustande kommen oder aber auch später aufgetrennt bzw. unterbrochen werden. Mögliche Ursachen hierfür sind Lötstellen bzw Verbindungsstellen oder Bonddrähte, bei denen beispielsweise im Herstellungsprozess selbst oder auch durch äußere Einwirkung keine oder eine nur unzureichende Verbindung hergestellt wurde, so dass entweder von Beginn an keine Verbindung besteht oder eine unzureichende Verbindung, die später vollends aufbricht. Auch können Probleme entstehen, wenn nicht zureichende Verbindungen nur zeitweise Schluss herstellen oder problematische Eigenschaften wie Abstrahlung, geänderter Widerstand oder ähnliches dadurch auftreten. Bekannte Probleme aus der Praxis sind beispielsweise sogenannte kalte Lötstellen oder abgetrennte Bonddrähte. In vielen Fällen ist dann keine ordnungsgemäße Funktion der Schaltung mehr gegeben.

Es ist somit Aufgabe der Erfindung, die genannte Problematik zu beheben und die Funktion zu garantieren.

### Vorteile der Erfindung

Diese Problematik wird durch ein Verfahren und eine entsprechende Vorrichtung zur Beschaltung von Konfigurationseingängen eines Mikrocontrollers behoben, wobei an jedem Konfigurationseingang ein Signalzustand aus wenigstens zwei möglichen Signalzuständen einzustellen ist und vorteilhafter Weise eine Energiequelle für jeden Konfigurationseingang vorgesehen ist und alle Energiequellen durch ein Konfigurationswort so eingestellt werden, dass ein vorgegebener Signalzustand aus den wenigstens zwei Signalzuständen an jedem Konfigurationseingang vorliegt.

Die entsprechende Vorrichtung zur Beschaltung von Konfigurationseingängen des Microcontrollers ist derart ausgebildet, dass an jedem Konfigurationseingang ein Signalzustand aus wenigstens zwei möglichen Signalzuständen einzustellen ist, wobei jedem Konfigurationseingang jeweils eine Energiequelle zugeordnet und mit diesem verbunden ist, welche mindestens zwei Zustände einnehmen kann, um die wenigstens zwei Signalzustände an jedem Konfigurationseingang einzustellen, wobei Einstellmittel vorgesehen sind, durch welche die Zustände jeder Energiequelle derart gesteuert werden, dass der vorgegebene Signalzustand für jeden Konfigurationseingang vorliegt.

D. h. durch individuell konfigurierbare Energiequellen kann ein bestimmtes Muster von Signalzuständen, insbesondere ein logisches Muster bei Signalzuständen 0 und 1 an den Konfigurationseingängen, welches für die korrekte Funktion der Schaltung bzw. für die jeweilige Applikation erforderlich ist, weitestgehend autark, bis hin zu völlig selbstständig eingestellt werden und somit die Funktionen gewährleistet werden.

Dabei enthält die Energiequelle zweckmäßiger Weise für jeden einzustellenden Signalzustand eine eigene Stromquelle. Dann ist es vorteilhafter Weise möglich, durch einfaches Umschalten zwischen den einzelnen Stromquellen den jeweiligen Signalzustand einzustellen.

Zweckmäßiger Weise handelt es sich bei den Stromquellen der Energiequelle jeweils um eine Pull-up-Stromquelle und eine Pull-down-Stromquelle, wobei gleichzeitig Schaltmittel vorgesehen sind, die zwischen den beiden Stromquellen umschalten.

Vorteilhafter Weise ist das Einstellmittel ein Konfigurationsregister vorgesehen, das insbesondere das Konfigurationswort aufnimmt, welches für jeden Konfigurationseingang eine Registerzelle enthält.

Damit ist zweckmäßiger Weise jede Registerzelle einer Energiequelle und einem Konfigurationseingang eindeutig zugeordnet.

Aus Sicherheitsgründen ist zweckmäßiger Weise wenigstens eine zusätzliche Registerzelle vorgesehen, durch welche die übrigen Registerzellen, also das Konfigurationswort blockierbar und/freigebbar ist, wobei die zusätzliche Registerzelle, diese Enable-Registerzelle, entweder im Konfigurationsregister enthalten ist oder diesem zugeordnet ist und außerhalb lokalisiert ist.

Zur Signalanpassung sind zweckmäßiger Weise zwischen das Einstellmittel und die Konfigurationseingänge Signalaufbereitungsmittel geschaltet, insbesondere ist zwischen jeden Konfigurationseingang und jede Registerzelle ein Signalaufbereitungsbaustein geschaltet, um die Signalanpassung vorzunehmen.

Die Konfigurationgseingänge sind also mit den Energiequellen verbunden und zwischen dem Einstellmittel, also insbesondere dem Konfigurationsregister, sind entsprechend der Anzahl der Konfigurationseingänge einzelne Verbindungen zur Einstellung der Signalzustände vorgesehen. Alternativ kann zwischen den Energiequellen und Konfigurationseingängen, die miteinander verbunden sind und dem Einstellmittel eine Verbindung vorgesehen sein, die eine Anzahl von Verbindungsleitungen enthält, die geringer ist als die Anzahl der zu konfigurierenden Konfigurationseingänge, wobei dann eine Kodier- und Dekodiereinrichtung vorgesehen ist, um durch eine binäre Kodierung die richtigen Energiequellen bzw. Konfigurationseingänge anzusprechen. Dies kann soweit gehen, dass lediglich eine Eindrahtverbindung verwendet wird.

In der bevorzugten Ausführungsform werden genau zwei Signalzustände eingestellt, insbesondere eine logische 1 bei Vorliegen von Versorgungsspannung und eine logische 0, bei Vorliegen von Masse.

Das Verfahren zur Beschaltung von Konfigurationseingängen kann dann dazu benutzt werden, bei einem Testbetrieb an den Konfigurationseingängen jeweils einen anderen Signalzustand einzustellen, eben durch Verwendung des Konfigurationswortes, als der der ursprünglich eingestellt und vorgesehen ist. D. h. vorteilhafter Weise ist bei einem Testbetrieb an den Konfigurationseingängen jeweils ein Signalzustand eingestellt, wobei durch das Konfigurationswort ein davon unterschiedlicher Signalzustand vorgegeben wird und sich der unterschiedliche Signalzustand nur gegenüber dem eingestellten Signalzustand durchsetzt wenn ein Fehler bezüglich des eingestellten Signalzustandes des jeweiligen Konfigurationseingangs vorliegt, was dann im Rahmen des Testbetriebs erkannt werden kann.

Weitere Vorteile und vorteilhafte Ausgestaltungen ergeben sich aus der Beschreibung sowie den Merkmalen der Ansprüche.

### Zeichnung

Die Erfindung wird nachfolgend anhand der in der Zeichnung dargestellten Figuren näher erläutert.

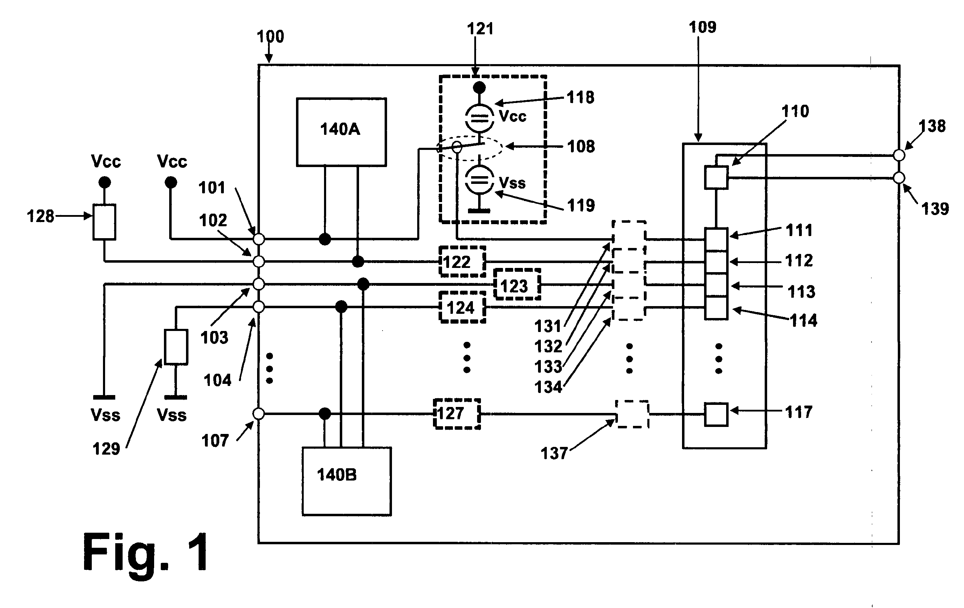

Dabei zeigt Figur 1 einen Micorcontroller mit einer erfindungsgemäßen Vorrichtung zur Sicherstellung der Signalzustände.

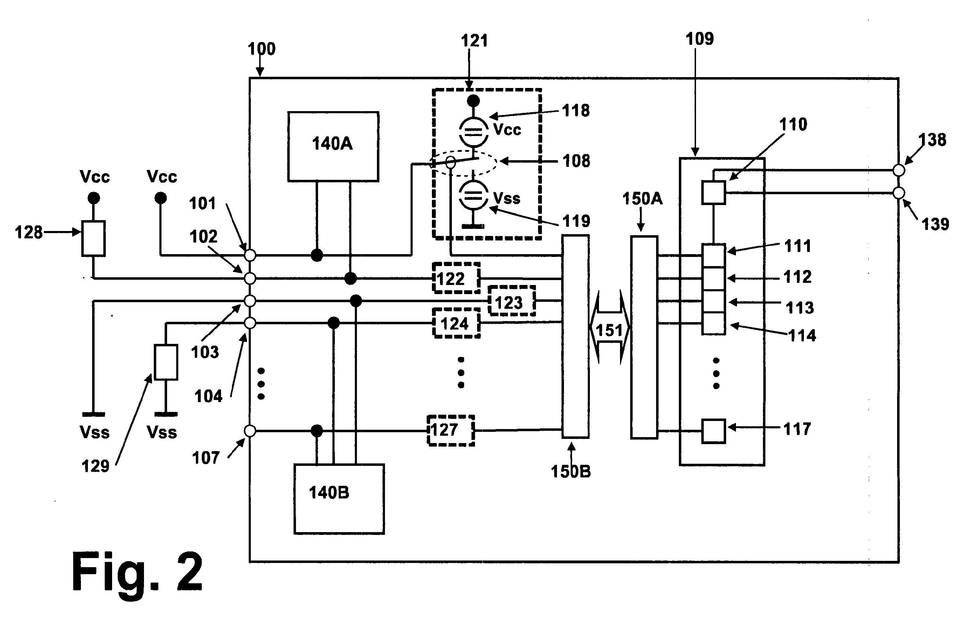

Figur 2 zeigt ebenfalls eine erfindungsgemäße Vorrichtung, bei der allerdings eine geringere Anzahl von Verbindungen zwischen Einstellmittel und Konfigurationseingängen vorgesehen ist.

Die Erfindung wird nachfolgend anhand der Ausführungsbeispiele näher erläutert.

### Ausführungsbeispiele

Figur 1 zeigt einen Microcontroller 100 mit System- und Konfigurationseingängen, die wie bereits erwähnt nur als Konfigurationseingänge bezeichnet werden mit der Benummerung 101 bis 107. Durch die drei Punkte ist dabei angedeutet, dass eine beliebige Anzahl solcher Konfigurationseingänge vorliegen kann. Mit 140A und 140B sind interne Microcontrollerfunktionseinheiten schematisch als Block dargestellt und graphisch zusammengefasst. 121 bis 127 zeigt jeweils eine Energiequelle, eben entsprechend der Anzahl der zu beschaltenden Konfigurationseingänge, wobei hier durch die drei Punkte auch deren beliebige Anzahl entsprechend der Anzahl der zu beschaltenden Konfigurationseingänge angedeutet ist. Mit 109 ist das Einstellmittel, hier speziell ein Konfigurationsregister, dargestellt. In diesem befinden sich Speicher- bzw. Registerzellen 111 bis 117, welche in ihrer Anzahl insbesondere der Anzahl der Konfigurationseingänge entsprechen. Diese Speicherzellen oder Registerzellen 111 bis 117 dienen der Steuerung der Energiequellen, insbesondere der internen Stromquellen, wie noch näher beschrieben wird. Die Registerzelle 110 dient zum Blockieren oder Freischalten der Registerzellen 111 bis 117, in denen das Konfigurationswort ablegbar ist. Dies kann über einen optionalen externen Eingang 139 erfolgen, durch welchen das Blockieren und/oder Freischalten möglich ist. Diese Enablingregisterzelle 110 kann aber auch intern im Microcontroller selbst mit dem Ablegen des Konfigurationswortes beschrieben werden, wodurch der externe Eingang 139 obsolet wäre. Mit 138 ist ein Ausgang bezeichnet, der ebenfalls optional ist und den Status der zusätzlichen Registerzelle 110 als Enablingregisterzelle auslesbar macht. Mit 131 bis 137 ist optional eine Signalaufbereitung vorgesehen, um eben beispielsweise eine Pegelanpassung, beispielsweise mit Schmitt-Triggern, falls erforderlich zu ermöglichen.

In diesem Beispiel sind die Konfigurationseingänge 101 bis 107 fest mit einer Versorgungsspannung Vcc oder mit einem Massepotential Vss verbunden, wobei beispielhaft Widerstände 128 und 129 als Pull-up- oder Pull-down Widerstand dargestellt sind. Neben diesen beiden Potentialen Vcc und Vss ist es auch möglich, mehr als zwei Potentiale und damit mehr als zwei Signalzustände an den Konfigurationseingängen 101 bis 107 vorzusehen. Im weiteren Beispiel wird aber von zwei Potentialen der Versorgungsspannung Vcc und der Masse Vss ausgegangen, wobei die Versorgungsspannung Vcc dabei beispielhaft eine logische 1 und die Masse Vss eine logische 0 repräsentiert.

Für die korrekte Funktion der Schaltung sind nun also diese Konfigurationseingänge des Microcontrollers nach einem vorgegebenen funktionsrelevanten Muster zu beschalten. Um dies erfindungsgemäß zu gewährleisten sind zusätzliche Energiequellen 121 bis 127 je Konfigurationseingang vorgesehen, welche in diesem Beispiel intern über eine Pull-up-Stromquelle 118 und eine Pull-down-Stromquelle 119 sowie ein Schaltmittel 108 zum Umschalten zwischen den beiden Stromquellen dargestellt ist. So verfügt der Microcontroller erfindungsgemäß über interne Pull-up- oder Pull-down-Stromquellen bzw. Energiequellen, die individuell konfigurierbar sind, wodurch ein bestimmtes logisches Muster, das für die jeweilige Applikation erforderlich ist, autark realisiert werden kann bzw. sofern eine äussere Beschaltung vorhanden ist bei Ausfall an einem Konfigurationseingang dieser Fehler behoben werden kann.

So ermöglicht die Erfindung einen sicheren Betrieb der Schaltung, also insbesondere des Microcontrollers auch bei einer fehlerhaften Verbindung zu einer potentiellen externen Beschaltung, über die der Anwender den Micorcontroller gemäß der anwendungsspezifischen Anforderungen konfigurieren kann. Wichtiges Bestandteil der Erfindung ist ein individuell definierbares Einstellmittel 109, eben beispielsweise ein Konfigurationsregister oder ein darin abgelegtes Konfigurationswort, durch welches die Energiequellen 121 bis 127, insbesondere die Pull-up- und Pull-down-Stromquellen 118 und 119 oder auch spezielle Widerstände im Rahmen einer Energiequelle steuert. Energiequellen, die die erfindungsgemäßen Eigenschaften aufweisen, sind in vielfacher Hinsicht denkbar, nachfolgend wird nur allgemein von Energiequelle bzw. von Pull-up-oder Pull-down-Stromquellen gesprochen, obwohl natürlich auch durch spezielle Widerstandsbeschaltung, Batterien, Akkumulatoren oder ähnliches solche Energiequellen insbesondere als Stromquellen oder Spannungsquellen, realisierbar sind. Jeder Konfigurationseingang 101 bis 107 ist dabei jeweils mit einer Energiequelle 121 bis 127, hier speziell jeweils mit einer Pull-up-Stromquelle 118 und einer Pull-down-Stromquelle 119 ausgestattet.

In einer ersten Ausführungsform sind die internen Stromquellen bzw. die Energiequelle nur so stark ausgeführt, dass der durch die Energiequelle bzw. die Pull-up- und Pull-down-Stromquellen vorgegebenen Signalzustände durch eine potentiell vorhandene externe Beschaltung überschrieben werden können. Über das Einstellmittel, eben speziell das Konfigurationsregister 109 kann nun individuell für jedes Eingangssignal eben für jeden Konfigurationseingang der Signalzustand, hier der logische Status 0 oder 1 vorgegeben werden, der sich einstellt, wenn die Verbindung zu der externen Beschaltung, über die der Anwender das Sollverhalten des Microcontrollers einstellt, nicht durch einen Fehler unterbrochen wurde. In diesem Fall ist trotz einer Unterbrechung der elektrischen Verbindung zur externen Beschaltung immer noch die gewünschte Funktion des Microcontrollers gegeben, da das jeweilige erforderliche logische Muster, also die Summe der jeweiligen Signalzustände zusätzlich über ein Konfigurationswort im Konfigurationsregister eingestellt wurde.

In einer zweiten Ausführungsform sind die internen Energiequellen 121 bis 127 bzw. die beispielhaften internen Pull-up- und Pull-down-Stromquellen 118 und 119 so stark ausgeführt, dass sich ein eindeutiger Zustand unter allen Umständen einstellt (z.B. bei EMV-Einstrahlung oder Masseversatz). So kann die externe Verbindung in dieser zweiten Ausführungsform ganz entfallen und es ist eine autarke interne Versorgung möglich. Dabei sollte aber dann bereits bei der Herstellung des Microcontrollers das erforderliche Konfigurationswort im Konfigurationsregister, also im Einstellmittel gesetzt werden, oder aber eine Programmierung des Konfigurationswortes im Konfigurationsregister vor Einsatz des Microcontrollers, insbesondere durch den Anwender sichergestellt werden.

In allen Ausführungsformen kann das Einstellmittel auch als Speicher mit größerem Umfang oder in einer anderen denkbaren Form ausgestaltet sein, wobei hier die einfachste Form als Konfigurationsregister mit einzelnen Speicherzellen bzw. Registerzellen und einzelnen Bits zur Beschreibung verwendet wird.

Dabei ist jeweils eine Speicherzelle oder Registerzelle in dem Konfigurationsregister, also dem Konfigurationswort mit einer Energiequelle, also hier speziell mit einer Einheit aus Pull-up- und Pull-down-Stromquelle an einem Konfigurationseingang des Microcontrollers 100 verbunden. Insgesamt sind also so viele Speicherbereiche bzw. Registerzellen vorhanden wie Konfigurationseingänge, also Eingangspins mit entsprechender Funktion vorliegen. Je nach logischem Zustand der Registerzelle, also insbesondere bei einer binären Kodierung 0 oder 1 in dem Konfigurationswort, wird entweder die Pull-up-Stromquelle 118 oder die Pull-down-Stromquelle 119 eingeschaltet. Bei einer 0 in dem Register wird z.B. die Pull-down-Stromguelle 119 des betrachteten Eingangs eingeschaltet, was dann auch einer logischen 0 am Konfigurationseingang 101 entspricht. Mit einer logischen 1 in dem Register 111 würde dann die Pull-up-Stromquelle 118 eingeschaltet, was z.B. einer logischen 1 am Konfigurationseingang 101 entspräche. Das Konfigurationsregister bzw. das Konfigurationswort kann z.B. als programmierbares Wort in einem nichtflüchtigen mehrfach programmierbaren Speicher wie z.B. Flashspeicher, EPROM- oder EEPROM-Speicher, aber auch in nichtflüchtigen einmal programmierbaren Speichern wie PROM oder aber, insbesondere bereits bei der Herstellung des Microcontrollers, in einem ROM realisiert werden.

Dabei kann bei mehrfach beschreibbaren Speichern ein Schutzmechanismus vorgesehen werden, der ein versehentliches Überschreiben des Konfigurationswortes verhindert, eben ein Schreibschutz. Dieser Schutz könnte z.B. durch ein zusätzliches Verriegelungsbit oder Enable-Bit 110 realisiert werden, durch welches abhängig von dessen Zustand das Konfigurationswort schreibbar oder blockiert ist. Über dieses Verriegelungs- oder Aktivierungsbit, also das Enable-Bit 110, wird das Konfigurationswort aktiv geschaltet. Sobald das Konfigurationswort aktiviert wurde, sind z.B. die entsprechend dem Status des Konfigurationswortes konfigurierten Energiequellen, insbesondere Stromquellen, mit den Konfigurationseingängen elektrisch verbunden. Dies gilt für jeden Betriebszustand des Microcontrollers. Im inaktiven Zustand wird die Konfiguration des Microcontrollers ausschließlich über die externe Beschaltung gesteuert, sofern eine solche vorhanden ist. Ansonsten ist eben darauf zu achten, dass die Konfiguration durch ein entsprechendes Konfigurationswort vorliegt. In der speziellen Ausführungsform zweier Stromquellen mit Auswahlschaltern, also Schaltmittel 108 dazwischen, ist es vorteilhaft, wenn der Auswahlschalter 108 sich zwischen den Stromquellen befindet, und zwar in Mittelstellung, wodurch der Schaltungszweig zu den Konfigurationseingängen hochohmig ist. Alternativ könnte das Enable-Bit, also die zusätzliche Registerzelle, auch durch einen externen Microcontrollereingang 139 gesteuert werden, was optional in den Figuren 1 und 2 dargestellt ist. Der jeweilige Status dieser zusätzlichen Registerzelle 110 mit dem Enabling-Bit zur Aktivierung oder Inaktivierung des internen Konfigurationsortes kann also wie der jeweilige Status aktiv/nicht aktiv über einen Statusausgang 138, z.B. binär high/low angezeigt werden. Auch dieser Statusausgang 138 ist optional in Figur 1 und 2 dargestellt. Vorteilhaft ist es, wenn der Status des gesamten Konfigurationswortes, also hier bei binärer Darstellung das binäre Muster durch den Microcontroller per Software auslesbar ist. Ebenso vorteilhaft ist es, wenn der jeweilige logische Status der Konfigurationseingänge 101 bis 107, insbesondere per Software ausgelesen werden kann. Dabei ist es dann wichtig, dass das gewählte logische Muster von Signalzuständen an den Konfigurationseingängen entsprechend einem logischen Muster im Konfigurationswort den gewünschten Zustand angenommen hat wenn der Status durch den Microcontroller abgefragt wird. Dies gilt gleichermaßen für Signale die nur einmalig z.B. bei der Freigabe des Resets des Microcontrollers eingelesen werden, wie auch für Signale, die permanent durch die internen Funktionseinheiten des Microcontrollers abgefragt werden. Dabei ist zweckmäßiger Weise für Signale, die bei Freigabe des Resets des Microcontrollers eingelesen werden, eine direkte elektrische Verbindung zwischen dem Konfigurationswort, also dem Konfigurationsregister und die Energiequellen, insbesondere den Stromquellen, vorzusehen. In einem solchen Fall kann das Konfigurationswort dann nicht per Softwareprotokoll übertragen werden. Eine solche Softwareprotokollübertragung ist beispielsweise in Figur 2 möglich, in der eine Variation in der Verbindung zwischen Einstellmittel und der Kombination Energiequelle/Konfigurationseingang dargestellt ist. Alle übrigen Bezeichnungen sind wie in Figur 1 beibehalten, lediglich die Signalaufbereitungsmittel 131 bis 137 sind der Übersichtlichkeit halber weggelassen. Diese Signalaufbereitung zwischen Konfigurationswort und Stromquelle kann z.B. eine Schaltung zur Pegelanpassung mit z.B. Schmitt-Triggern sein.

Werden Flash-Speicher oder ähnliche Techniken zur Speicherung des Konfigurationswortes eingesetzt, dann sind ausserdem entsprechende Dekodier- und Leseschaltungen (150A, 150B) vorzusehen. Solche Dekodier- und Leseschaltungen sind ebenfalls vorzusehen, wenn eine Übertragung über weniger Leitungen erfolgen soll, als die Anzahl der Konfigurationseingänge dies prinzipiell erfordern würde. Bei einer Anzahl von Verbindungsleitungen auf einer Verbindung 151, die geringer ist als die Anzahl der Konfigurationseingänge 101 bis 107 ist ein Codierbaustein 150A sowie ein Decodierbaustein 150B erforderlich. Dabei ist es zum einen möglich, eine geringere Anzahl von Leitungen in der Form zu verwenden, dass alle Energiequellen codiert angesprochen werden können. Sind beispielsweise 4 Konfigurationseingänge zu beschalten, kann die Übertragung über zwei Leitungen erfolgen, da über 2² =4 die 4 Konfigurationseingänge binär codierbar sind. Bei entsprechend vier Leitungen in Verbindung 151 können entsprechend bis zu 16 (2⁴) Konfigurationseingänge codiert werden, usw. Alternativ könnte auch eine Eindrahtverbindung 151 realisiert werden, über die die Information des Konfigurationswortes per Softwareprotokoll übertragen wird, was sich dann auch in der Gestaltung der Codiervorrichtung 150A und der Decodiervorrichtung 150B auswirkt.

Wie bereits vorher erwähnt ist die einfachste Form eines Konfigurationsregisters als Einstellmittel gewählt mit einzelnen Registerzellen, in denen einzelne Bits ein Gesamtmuster als Konfigurationswort ergeben. Ebenso ist es aber natürlich möglich, speziell bei mehr als zwei einstellbaren Zuständen an den Konfigurationseingängen andere Kennungen und damit größere Speicherzellen 111 bis 117 vorzusehen. Sind z.B. drei Zustände an den Konfigurationseingängen zu unterscheiden, sind zur Codierung in einer Speicherzelle 111 bis 117 schon wenigstens zwei Bit (2²=4), usw erforderlich. D. h. je nach Anzahl der zu codierenden Zustände können natürlich auch die Speicherzellen umfangreicher gewählt werden.

Durch das erfindungsgemäße Verfahren und die Vorrichtung zur Beschaltung der Konfigurationseingänge eines Microcontrollers lässt sich nun auch ein Testbetrieb, also ein Testverfahren realisieren, insbesondere wenn das Konfigurationswort in einem mehrfach programmierbaren nichtflüchtigen Speicher realisiert wird, da sich dann widersprüchliche Anforderungen zum Testbetrieb kombinieren lassen. Zum einen ist dann ein Test der externen Verbindungen bei externer Beschaltung möglich, d. h. die Schaltung funktioniert nicht, wenn eine externe Verbindung unterbrochen wurde und zum anderen ist ein maximal robuster Betrieb der Schaltung gegeben, d. h. die Schaltung funktioniert auch bei unterbrochener elektrischer Verbindung zu einer externen Beschaltung. D.h. an einer externen Beschaltung des Microcontrollers ist der Sollzustand an jedem Konfigurationseingang des Microcontrollers eingestellt. Das Konfigurationswort im Einstellmittel wird dann so programmiert, dass an den jeweiligen Konfigurationseingängen die Energiequellen den entgegengesetzten Signalzustand zur externen Beschaltung annehmen. Ist nun die externe Verbindung nicht vorhanden, so nimmt der Microcontroller den Modus ein, der über das Konfigurationsregister eingestellt wurde. Dieser entspricht dann aber nicht dem Modus, der über die externe Beschaltung vorgegeben wurde. Das unterschiedliche Verhalten kann dann erkannt und somit eine nicht ordnungsgemäße externe Verbindung festgestellt und lokalisiert werden.

Ist die externe Verbindung jedoch ordnungsgemäß vorhanden, also zur externen Beschaltung, so überschreibt die starke externe Verbindung in der ersten Ausführungsform die schwächere interne Energiequelle, insbesondere Stromquelle, so dass der Microcontroller den erwarteten Modus gemäß der externen Beschaltung einnimmt. Wenn der Test der externen Beschaltung erfolgreich durchlaufen wurde, kann das interne Konfigurationswort invertiert werden. Das interne Konfigurationswort und die externe Beschaltung sind somit gleichsinnig, wodurch die Verfügbarkeit erhöht wird. Kommt es nun später zu einer Unterbrechung einer Verbindung zur externen Beschaltung, also zur Unterbrechung einer externen Verbindung, so ist immer noch eine korrekte Funktion der Schaltung gegeben, da der vorgegebene Modus für den Microcontroller zusätzlich über das interne Konfigurationswort eingestellt wurde. Damit ist Redundanz und eine Erhöhung der Sicherheit erfindungsgemäß gegeben.

## Patentansprüche

1. Vorrichtung zur Beschaltung von Konfigurationseingängen (101-107) eines Mikrocontrollers, wobei die Vorrichtung derart ausgebildet ist, dass an jedem Konfigurationseingang (101-107) ein Signalzustand aus wenigstens zwei möglichen Signalzuständen einzustellen ist, **dadurch gekennzeichnet, dass** mit jedem Konfigurationseingang (101-107) jeweils wenigstens eine Energiequelle (121-127) verbunden ist, welche mindestens zwei Zustände einnehmen kann, um die wenigstens zwei Signalzustände an jedem Konfigurationseingang einzustellen, wobei Einstellmittel (109) vorgesehen sind durch welche die Zustände jeder Energiequelle derart gesteuert werden, dass der vorgegebene Signalzustand für jeden Konfigurationseingang vorliegt.

2. Vorrichtung nach Anspruch 1, **dadurch gekennzeichnet, dass** jede Energiequelle (121-127) für jeden einzustellenden Signalzustand eine Stromquelle (118, 119) enthält.

3. Vorrichtung nach Anspruch 1, **dadurch gekennzeichnet, dass** jede Energiequelle (121) aus einer Pull-up Stromquelle (118) und einer Pull-down Stromquelle (119) aufgebaut ist und Schaltmittel (108) enthält, die zwischen beiden Stromquellen umschalten.

4. Vorrichtung nach Anspruch 1, **dadurch gekennzeichnet, dass** als Einstellmittel (109) ein Konfigurationsregister vorgesehen ist, welches für jeden Konfigurationseingang (101-107) eine Registerzelle (111-117) enthält.

5. Vorrichtung nach Anspruch 4, **dadurch gekennzeichnet, dass** jede Registerzelle (111-117) einer Energiequelle (121-127) und einem Konfigurationseingang (101-107) zugeordnet ist.

6. Vorrichtung nach Anspruch 4, **dadurch gekennzeichnet, dass** wenigstens eine zusätzliche Registerzelle (110) vorgesehen ist, durch welche die übrigen Registerzellen (111-117) blockierbar und/oder freigebbar sind, wobei die zusätzliche Registerzelle (110) im Konfigurationsregister (109) enthalten oder diesem zugeordnet ist.

7. Vorrichtung nach Anspruch 1, **dadurch gekennzeichnet, dass** zwischen das Einstellmittel (109) und die Konfigurationseingänge (101-117) Signalaufbereitungsmittel (131-137) geschaltet sind.

8. Vorrichtung nach Anspruch 4 und 7, **dadurch gekennzeichnet, dass** zwischen jeden Konfigurationseingang (101-107) und jede Registerzelle (111-117) ein Signalaufbereitungsbaustein (131-137) geschaltet ist.

9. Vorrichtung nach Anspruch 1, **dadurch gekennzeichnet, dass** zwischen den miteinander verbundenen Konfigurationseingängen und Energiequellen und dem Einstellmittel eine Eindrahtverbindung (151) vorgesehen ist, wobei dazu eine Codier-(150Λ) und Decodiereinrichtung (150B) vorgesehen ist.

10. Vorrichtung nach Anspruch 1, **dadurch gekennzeichnet, dass** zwischen den miteinander verbundenen Konfigurationseingängen und Energiequellen und dem Einstellmittel eine Verbindung (151) vorgesehen ist und die Verbindung eine Anzahl Verbindungsleitungen enthält, wobei die Anzahl so vorgesehen ist, das die Konfigurationseingänge binär codiert werden können, wobei dazu eine Codier- (150A) und Decodiereinrichtung (150B) vorgesehen ist.

11. Vorrichtung nach Anspruch 1, **dadurch gekennzeichnet, dass** die Vorrichtung so ausgebildet ist, dass genau zwei Signalzustände einstellbar sind.

12. Mikrocontroller mit einer Vorrichtung nach Anspruch 1.

13. Verfahren zur Beschaltung von Konfigurationseingängen (101-107) eines Mikrocontrollers, wobei an jedem Konfigurationseingang (101-107) ein Signalzustand aus wenigstens zwei möglichen Signalzuständen einzustellen ist, **dadurch gekennzeichnet, dass**
eine Energiequelle (121-127) für jeden Konfigurationseingang (101-107) vorgesehen ist, und alle Energiequellen durch ein Konfigurationswort so eingestellt werden, dass ein vorgegebener Signalzustand aus den wenigstens zwei Signalzuständen an jedem Konfigurationseingang vorliegt.

14. Verfahren nach Anspruch 13, **dadurch gekennzeichnet, dass** bei einem Testbetrieb an den Konfigurationseingängen jeweils ein Signalzustand eingestellt ist und durch das Konfigurationswort ein davon unterschiedlicher Signalzustand vorgegeben wird, wobei sich der unterschiedliche Signalzustand sich nur gegenüber dem eingestellten Signalzustand dann durchsetzt, wenn ein Fehler bezüglich des eingestellten Signalzustands des jeweiligen Konfigurationseingans vorliegt.

## Claims

1. Apparatus for the connection of configuration inputs (101-107) of a microcontroller, with the apparatus being designed such that one signal state from at least two possible signal states can be set at each configuration input (101-107), **characterized in that** at least one energy source (121-127) is in each case connected to each configuration input (101-107) and can assume at least two states in order to set the at least two signal states at each configuration input, with setting means (109) being provided, by means of which the states of each energy source are controlled such that the predetermined signal state is produced for each configuration input.

2. Apparatus according to Claim 1, **characterized in that** each energy source (121-127) contains a power source (118, 119) for each signal state which can be set.

3. Apparatus according to Claim 1, **characterized in that** each energy source (121) is formed from a pull-up power source (118) and a pull-down power source (119), and contains switching means (108) which switch between the two power sources.

4. Apparatus according to Claim 1, **characterized in that** a configuration register is provided as the setting means (109), and contains one register cell (111-117) for each configuration input (101-107)

5. Apparatus according to Claim 4, **characterized in that** each register cell (111-117) is associated with one energy source (121-127) and one configuration input (101-107).

6. Apparatus according to Claim 4, **characterized in that** at least one additional register cell (110) is provided and allows the other register cells (111-117) to be blocked and/or released, with the additional register cell (110) being contained in or associated with the configuration register (109).

7. Apparatus according to Claim 1, **characterized in that** signal pre-processing means (131-137) are connected between the setting means (109) and the configuration inputs (101-117).

8. Apparatus according to Claims 4 and 7, **characterized in that** a signal pre-processing module (131-137) is connected between each configuration input (101-107) and each register cell (111-117).

9. Apparatus according to Claim 1, **characterized in that** a single-wire connection (151) is provided between the configuration inputs and energy sources which are connected to one another, and the setting means, with a coding device (150A) and a decoding device (150B) being provided for this purpose.

10. Apparatus according to Claim 1, **characterized in that** a connection (151) is provided between the configuration inputs and energy sources which are connected to one another and the setting means, and the connection contains a number of connecting lines, with the number being provided such that the configuration inputs can be binary coded, with a coding device (150A) and decoding device (150B) being provided for this purpose.

11. Apparatus according to Claim 1, **characterized in that** the apparatus is designed such that two and only two signal states can be set.

12. Microcontroller having an apparatus according to Claim 1.

13. Method for the connection of configuration inputs (101-107) of a microcontroller, in which, one signal state from at least two possible signal states can be set at each configuration input (101-107),
**characterized in that**
one energy source (121-127) is provided for each configuration input (101-107) and all the energy sources are set by means of a configuration word such that one predetermined signal state from the at least two signal states is produced at each configuration input.

14. Method according to Claim 13, **characterized in that**, during a test mode, one signal state is set at each of the configuration inputs, and a signal state that differs from this is predetermined by the configuration word, with the different signal state from the set signal state being passed on only when an error is present with respect to the set signal state at the respective configuration input.

## Revendications

1. Dispositif de commutation des entrées de configuration (101-107) d'un microcontrôleur, le dispositif étant réalisé pour que chaque entrée de configuration (101-107) établisse un état de signal à partir d'au moins deux états possibles du signal,
**caractérisé en ce qu'**
à chaque entrée de configuration 101-107) est reliée respectivement au moins une source d'énergie (121-127) qui peut prendre au moins deux états pour régler au moins deux états de signal à chaque entrée de configuration,
des moyens de réglage (109) étant prévus pour commander les états de chaque source d'énergie de façon que l'état prédéfini du signal existe pour chaque entrée de configuration.

2. Dispositif selon la revendication 1,
**caractérisé en ce que**
pour chaque état de signal à régler, chaque source d'énergie (121-127) comporte une source de courant (118, 119).

3. Dispositif selon la revendication 1,
**caractérisé en ce que**
chaque source d'énergie (121) est formée d'une source de courant (118) de relevage et d'une course de courant (119) d'abaissement et comporte des moyens de commutation (108) qui commutent entre les deux sources de courant.

4. Dispositif selon la revendication 1,
**caractérisé en ce que**
le moyen de réglage (109) est un registre de configuration comportant une cellule de registre (111-117) pour chaque entrée de configuration (101-107).

5. Dispositif selon la revendication 4,
**caractérisé en ce qu'**
à chaque cellule de registre (111-117) est associée une source d'énergie (121-127) et une entrée de configuration (101-107).

6. Dispositif selon la revendication 4,
**caractérisé par**
au moins une cellule de registre supplémentaire (110) qui permet de bloquer et/ou de libérer les autres cellules de registre (111-117),
la cellule de registre supplémentaire (110) étant contenue dans le registre de configuration (109) ou associée à celui-ci.

7. Dispositif selon la revendication 1,
**caractérisé par**
un moyen de préparation de signal (131-137) entre le moyen de réglage (109) et les entrées de configuration (101-117).

8. Dispositif selon les revendications 4 et 7,
**caractérisé par**
un composant de préparation de signal (131-137) prévu entre chaque entrée de configuration (101-107) et chaque cellule de registre (111-117).

9. Dispositif selon la revendication 1,
**caractérisé par**
une liaison à un fil (151) entre les entrées de configuration reliées entre elles et les sources d'énergie ainsi que le moyen de réglage, et pour cela il est prévu une installation de codage (150A) et une installation de décodage (150B).

10. Dispositif selon la revendication 1,
**caractérisé en ce qu'**
entre les entrées de configuration reliées et les sources d'énergie et le moyen de réglage il est prévu une liaison (151) et cette liaison comporte un certain nombre de lignes de liaison, le nombre étant prévu pour que les entrées de configuration puissent être codées en binaire et pour cela il est prévu une installation de codage (150A) et une installation de décodage (150B).

11. Dispositif selon la revendication 1,
**caractérisé en ce qu'**
il est conçu pour régler précisément deux états de signal.

12. Microcontrôleur comportant un dispositif selon la revendication 1.

13. Procédé de commutation des entrées de configuration (101-107) d'un microcontrôleur, chaque entrée de configuration (101-107) ayant un état de signal avec au moins deux états de signal qu'il est possible de régler,
**caractérisé en ce qu'**
une source d'énergie (121-127) est prévue pour chaque entrée de configuration (101-107) et toutes les sources d'énergie se règlent par un mot de configuration de façon à disposer d'un état de signal prédéfini formé d'au moins deux état s de signal à chaque entrée de configuration.

14. Procédé selon la revendication 13,
**caractérisé en ce que**
pour un mode de fonctionnement d'essai, les entrées de configuration sont réglées chaque fois avec un état de signal et le mot de configuration prédéfinit un état de signal différent du précédent,
et l'état de signal différent s'impose alors par rapport à l'état de signal réglé s'il existe une erreur concernant l'état de signal réglé de l'entrée de configuration respective.
